# EUROPEAN PATENT APPLICATION

(11) **EP 1 589 586 A1**
(43) Date of publication of application: **26.10.2005**
(21) Application number: 04702779.2
(22) Date of filing: 16.01.2004
(51) Int. Cl.: H01L 31/0203, C09K 3/00

(54) **TRANSPARENT RESIN COMPOSITION FOR OPTICAL SENSOR FILTER, OPTICAL SENSOR AND PRODUCTION METHOD THEREFOR**

(30) Priority: 20.01.2003 JP 2003011268
(71) Applicant: SHARP KABUSHIKI KAISHA, Osaka-shi, Osaka 545-8522 (JP)
(72) Inventor: KAMOSHITA, Shoichi, Yamatokoriyama-shi, Nara 6391054 (JP)
(74) Representative: Müller, Frithjof E.
(86) International application number: PCT/JP2004/000270
(87) International publication number: WO 2004/066398

(57) **Abstract**

It is an object of the present invention to provide a highly reliable optical sensor and a production process of the same, the optical sensor being excellent in the characteristic of blocking infrared radiation and capable of being manufactured at a low cost without an increase in the number of steps carried out in the assembly of electronic apparatus. The present invention includes: a substrate 1 having an electrode 3; a photodetector 2 electrically connected to the electrode 3; and a light-transmissive resin encapsulating portion 11 for encapsulating the photodetector 2 on the substrate 1, the optical sensor further including an infrared-blocking layer either inside the light-transmissive resin encapsulating portion 11 or on an outer surface of the light-transmissive resin encapsulating portion 11 for blocking infrared radiation from the outside from reaching the photodetector.

## Description

### Technical Field

The present invention relates to an optical sensor and a process of producing the same. More particularly, the present invention relates to a surface-mount-type optical sensor to be used for the switching between on and off or adjustment of a light amount of a backlight of a liquid crystal display such as a personal digital assistant and to a process of producing the optical sensor.

### Backgrouud Art

In recent years, a rapidly growing number of personal digital assistants including a mobile telephone have employed a TFT color liquid crystal display in their display section, and their power consumption has been rising accordingly. For the purpose of adding the function of turning off or down a backlight source when backlight is not needed (outdoors on a sunny day or indoors with bright illumination), surface-mount-type optical sensors having peak sensitivities at infrared wavelengths have commonly been employed as a component for detecting indoor or outdoor light.

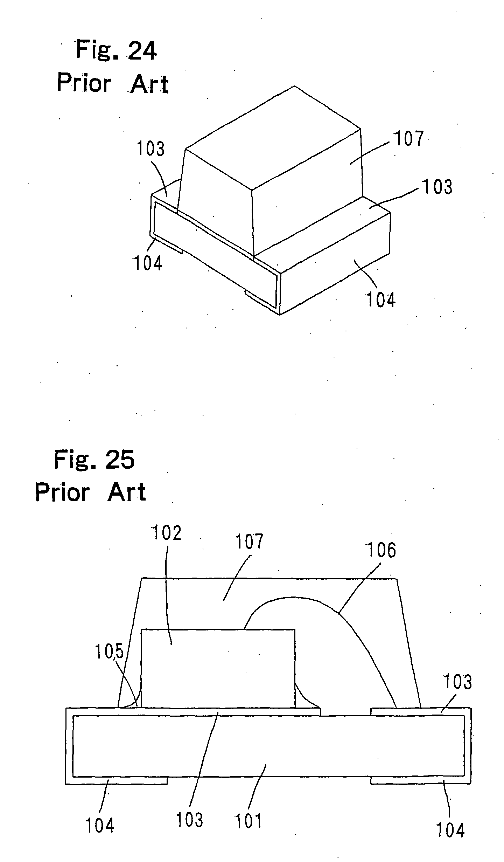

As such an optical sensor, for example, as shown in Figs. 24 and 25, there is known an optical sensor including, for example, a substrate 101; a first metal pad 103 connected to one of terminal electrodes 104 provided on a rear surface of the substrate 101; a second metal pad 103 connected to the other terminal electrode 104 on the rear surface of the substrate 101; a photodetector 102 mounted on the first metal pad 103 via a conductive adhesive 105; a small-gage metal wire 106 for electrically connecting the photodetector 102 and the second metal pad 103 together; and a resin encapsulating portion 107 made of a light-transmissive resin in substantially rectangular solid form to cover the photodetector 102 and the small-gage metal wire 106 (see Japanese Unexamined Utility Model No. Sho 61 (1986)-156250). This type of optical sensor, however, has a problem of malfunctioning: Where there is invisible infrared radiation at night or indoors with weak illumination for some reason, the optical sensor might detect the infrared radiation to judge that the surroundings are bright.

On this account, an increasing number of optical sensors have had an infrared-blocking filter separately provided at an upper part of their light-receiving portion. As an optical sensor having the function of blocking infrared radiation, there is known the one having two photodiodes mounted on one chip or separate chips wherein one photodiode has a peak sensitivity at a wavelength in the visible-light region and the other photodiode has a peak sensitivity at a wavelength in the infrared region and wherein, on the basis of results of detections of light by the respective photodiodes, calculation is made and it is judged whether or not the light is in the infrared region and, if the light is in the infrared region, the output of a detector is suspended (see Japanese Unexamined Patent Publication No. 2001-264161). In this case, however, a computing or amplifying function needs to be added to the photodiodes, so that the photodiodes become special in structure and expensive and, depending on the computational algorithm, there may be cases where infrared radiation is not blocked properly.

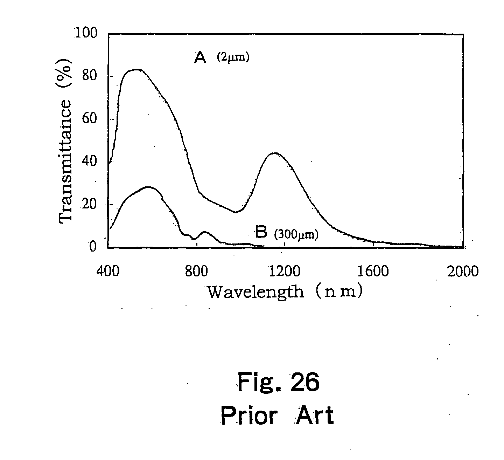

As a visible-light sensor for detecting only visible light, optical sensors having a photodetector encapsulated in a resin are disclosed in Japanese Unexamined Patent Publication Nos. Hei 01(1989)-266751 and Hei 10(1998)-229206. In a visible-light sensor of Japanese Unexamined Patent Publication No.. Hei 01(1989)-266751, a transparent resin contains glass powders that absorb infrared radiation. In this case, however, due to a significant difference between glass and resin in coefficient of linear expansion, the glass powders and the resin are interspaced from each other in a step such as heating or cooling carried out at resin molding, indicating that this sensor is not suitable for mass production. On the other hand, in resins that block infrared radiation employed in a visible-light sensor of Japanese Unexamined Patent Publication No. Hei 10 (1998)-229206 (the resins manufactured by Dai Nippon Toryo Co., Ltd.), their transmittances at near-infrared wavelengths ranging upwardly from 700 nm are not sufficiently low as compared to peak transmittances, as shown in Fig. 26. For example, in a resin A (acrylic resin) of a thickness of 2 *µ*m, its transmittance even at a wavelength of 800 nm is as high as about one thirds of a peak transmittance, whereas even in a resin B (epoxy resin) of a thickness of 300 *µ*m, its transmittance at a wavelength of 850 nm is about one fourths of a peak transmittance.

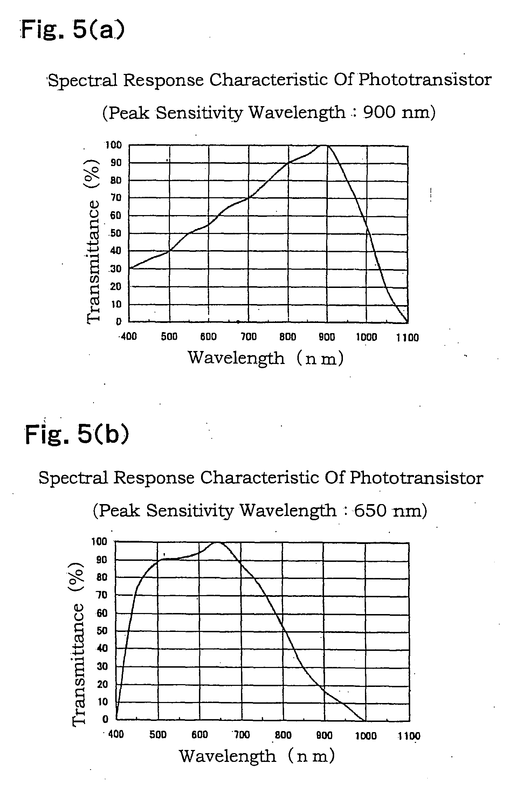

Figs. 5 show graphs illustrating different spectral response characteristics of two types of phototransistors (Si). A phototransistor shown in Fig. 5(a) has a peak sensitivity at a wavelength of 900 nm, whereas a phototransistor shown in Fig. 5(b) has a peak sensitivity at a wavelength of 650 nm. When one of the resins that blocks infrared radiation (resin A or B) is combined with the phototransistor shown in Fig. 5(a) having a peak transmittance at a wavelength of 900 nm to produce a visible-light sensor, the sensitivity of the visible-light sensor is in the near-infrared region of wavelengths of 800 nm to 900 nm. Even when one of the resins that blocks infrared radiation (resin A or B) is combined with the phototransistor shown in Fig. 5(b) having a peak transmittance at a wavelength of 650 nm to produce a visible-light sensor, the sensitivity of the visible-light sensor at near-infrared wavelengths ranging upwardly from 700 nm is not sufficiently low. Thus, use of these visible-light sensors is impractical.

### Disclosure of Invention

Under these circumstances, according to the present invention, there is provided an optical sensor (A) comprising: a substrate having an electrode; a photodetector electrically connected to the electrode; and a light-transmissive resin encapsulating portion for encapsulating the photodetector on the substrate, the optical sensor characterized by further comprising an infrared-blocking layer either inside the light-transmissive resin encapsulating portion or on an outer surface of the light-transmissive resin encapsulating portion for blocking infrared radiation from the outside from reaching the photodetector.

Also, according to the present invention, there is provided an optical sensor (B) comprising: a substrate having an electrode; a photodetector electrically connected to the electrode; and a light-transmissive resin encapsulating portion for encapsulating the photodetector on the substrate, the optical sensor characterized in that the light-transmissive resin encapsulating portion contains an infrared-absorbing substance. That is, the light-transmissive resin encapsulating portion is formed of a light-transmissive resin containing the infrared-absorbing substance, so that the light-transmissive resin encapsulating portion itself has the function of absorbing infrared radiation.

The optical sensors (A) and (B) thus constituted have the function of absorbing or reflecting light in the infrared region incorporated therein without an increase in the number of components and with a simple constitution. Thus, it is possible to save time and effort to incorporate an infrared-blocking filter, separately from the optical sensor, into electronic equipment such as a personal digital assistant, so that the electronic equipment can be manufactured at a low cost without an increase in the number of assembly steps. Further, according to the optical sensor (B), the light-transmissive resin encapsulating portion having the function of absorbing infrared radiation can be formed by one molding step, resulting in efficient manufacturing of the optical sensor without an increase in the number of manufacturing steps.

### Brief Description of Drawings

Fig. 1 is a perspective view showing an optical sensor according to Embodiment 1 of the present invention;
Fig. 2 is a front view in section showing the optical sensor according to Embodiment 1;
Figs. 3(a) to (e) are graphs showing relationships infrared-absorbing dyes have between an absorption peak sensitivity and a spectral transmittance;
Figs. 4(a) and (b) are graphs showing simulation results when infrared-absorbing dyes are blended;
Figs. 5 (a) and (b) are graphs showing different spectral response characteristics of two types of Si phototransistors;
Figs. 6(a) and (b) are graphs showing the spectral responses and infrared-absorbing dye simulations, of the phototransistors;
Figs. 7(a) to (g) are a flowchart showing the step of forming a resin encapsulating portion in the production of the optical sensor according to Embodiment 1;
Fig. 8 is a partial plan view showing one example of an electrode pattern to be used in the production of the optical sensor according to Embodiment 1;
Fig. 9 is a perspective view showing an optical sensor according to Embodiment 2 of the present invention;
Fig. 10 is a front view in section showing the optical sensor according to Embodiment 2;
Figs. 11(a) to (d) are a flowchart showing the step of forming a resin encapsulating portion in the production of the optical sensor according to Embodiment 2;
Figs. 12(a) to (d) are a flowchart showing the step of forming a resin encapsulating portion in the production of an optical sensor according to Embodiment 3;
Fig. 13 is a front view in section showing an optical sensor according to Embodiment 4 of the present invention;
Figs. 14 (a) to (d) are a flowchart showing the step of forming a resin encapsulating portion in the production of the optical sensor according to Embodiment 4;
Fig. 15 is a front view in section showing an optical sensor according to Embodiment 5 of the present invention;
Figs. 16(a) to (d) are a flowchart showing the step of forming a resin encapsulating portion in the production of the optical sensor according to Embodiment 5;
Fig. 17 is a front view in section showing an optical sensor according to Embodiment 6 of the present invention;
Figs. 18(a) to (e) are a flowchart showing the step of forming a resin encapsulating portion in the production of the optical sensor according to Embodiment 6;
Fig. 19 is a front view in section showing an optical sensor according to Embodiment 7 of the present invention;
Figs. 20(a) to (c) are a flowchart showing the step of forming a resin encapsulating portion in the production of the optical sensor according to Embodiment 7;
Fig. 21 is a front view in section showing an optical sensor according to Embodiment 8 of the present invention;
Figs. 22(a) to (c) are a flowchart showing the step of forming a resin encapsulating portion in the production of the optical sensor according to Embodiment 8;
Figs. 23(a) to (d) are a flowchart showing the step of forming a resin encapsulating portion in another process of producing the optical sensor according to Embodiment 8;
Fig. 24 is a perspective view showing a conventional optical sensor;
Fig. 25 is a front view in section showing the conventional optical sensor; and
Fig. 26 is a graph showing a characteristic of a resin that blocks infrared radiation and that is used in another conventional optical sensor.

### Best Mode for Carrying Out the Invention

In the optical sensor (A) according to the present invention, the infrared-blocking layer is a layer that allows light in the visible-light region (about 380 nm to 800 nm) to transmit through it and that allows light in the infrared region (about 800 nm to 10000 nm) to be absorbed in or reflected from it. More specifically., the infrared-blocking layer is made of either an infrared-absorbing layer containing an infrared-absorbing substance or an infrared-reflecting layer containing an infrared-reflecting substance.

The infrared-absorbing layer containing the infrared-absorbing substance may be either an infrared-absorbing film of a transparent resin containing the infrared-absorbing substance or a transparent resin layer containing the infrared-absorbing substance. The infrared-absorbing substance is suitably a phthalocyanine compound described in Japanese Unexamined Patent Publication No. 2001-106689 represented by the general formula (I): 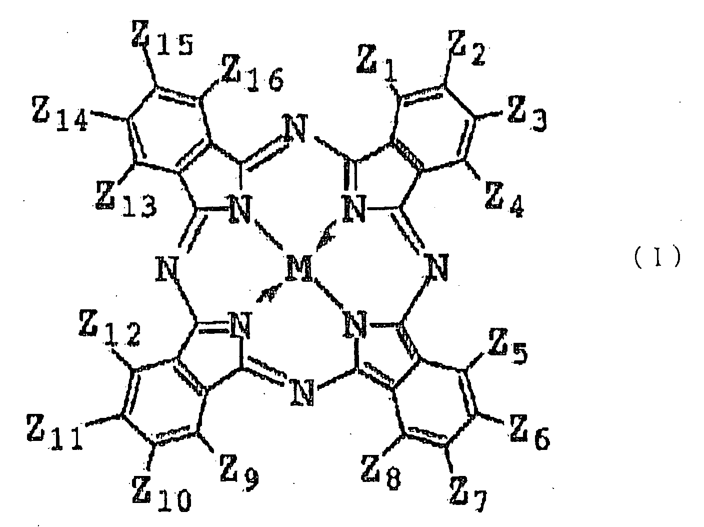 wherein Zi (i=1-16) is SR₁, OR₂, NHR₃ or a halogen atom, wherein R₁, R₂ and R₃ are a phenyl group which may have substituent(s), an aralkyl group which may have substituent(s) or a C₁-C₂₀ alkyl group which may have substituent(s); and M is a nonmetal, a metal, a metallic oxide or a metallic halide. Preferably, two or more of infrared-absorbing dyes having different characteristics are used in optimized combination to obtain the target characteristic of blocking infrared radiation in a wide range, resulting in an improved reliability of the optical sensor. In this case, depending on the target characteristic of blocking infrared radiation, an infrared-absorbing dye may be added in an amount of 0.1 wt% to 1.0 wt% with respect to 100 wt% of the transparent resin. When the infrared-absorbing dye is added in an amount of less than 0.1 wt% of with respect to 100 wt% of the transparent resin, the sensitivity rises but the infrared blockage effect is reduced. On the other hand, when infrared radiation dye is added in an amount of more than 1.0 wt%, the infrared blockage effect is improved but the sensitivity lessens.

The infrared-reflecting layer containing the infrared-reflecting substance may be either an infrared-reflecting multilayer film wherein a phase difference between wavelengths is utilized or a transparent resin layer or film containing the infrared-reflecting substance. Examples of infrared-reflecting substances include titanium dioxide, silicon dioxide and the like. Preferably, two or more of infrared-reflecting substances are used in optimized combination.

In the optical sensor (A) according to the present invention, the light-transmissive resin encapsulating portion may have an inner resin portion for encapsulating the photodetector and an outer resin portion for covering the inner resin portion. The infrared-blocking layer may be made of either an infrared-absorbing layer containing the infrared-absorbing substance or an infrared-reflecting layer containing the infrared-reflecting substance, which is interposed between the inner resin portion and the outer resin portion. When the infrared-blocking layer is formed inside the transparent resin encapsulating portion having a double-layer structure, the infrared-blocking layer can easily entirely cover the photodetector, resulting in an improved characteristic of blocking infrared radiation.

In the sensor (B) according to the present invention, the infrared-absorbing substance is suitably the phthalocyanine compound of the general formula (I). More specifically, two or more of infrared-absorbing dyes having different characteristics are preferably used in optimized combination to obtain the target characteristic of blocking infrared radiation in a wide range, resulting in a greatly improved reliability of the optical sensor. In this case, depending on the target characteristic of blocking infrared radiation, the infrared-absorbing dye may be added in an amount of 0.1 wt% to 1.0 wt% with respect to 100 wt% of the transparent resin. When the infrared-absorbing dye is added in an amount of less than 0.1 wt% with respect to 100 wt% of the transparent resin, the sensitivity rises but the infrared blockage effect is reduced. On the other hand, when the infrared-absorbing dye is added in an amount of more than 1.0 wt%, the infrared blockage effect is improved but the sensitivity lessens.

As described above, when the phthalocyanine-based dye represented by the general formula (I) which is an organic material is used as an infrared-absorbing material, the light-transmissive resin encapsulating portion can be formed by an ordinary resin-molding technique despite the fact that the light-transmissive resin (molded resin) contains the infrared-absorbing material. Thus, the present invention can realize the visible-light sensor capable of being down-sized and easily mass-produced.

The phthalocyanine compound may be prepared by the process described in Japanese Unexamined Patent Publication No. 2001-106689. In the preparation, M or Z in the above general formula (I) may be changed so as to adjust the wavelength at which the phthalocyanine compound has an absorption peak.

In the phthalocyanine compound represented by the general formula (I), examples of substituents optionally contained in a phenyl group or an aralkyl group include halogen atom, acyl, alkyl, phenyl, alkoxyl, alkyl halide., alkoxyl halide, nitro, amino, alkylamino, alkylcarbonylamino, arylamino, arylcarbonylamino, carbonyl, alkoxycarbonyl, alkylaminocarbonyl, alkoxysulfonyl, alkylthio, carbamoyl, aryloxycarbonyl, oxyalkylether and cyano groups and the like. The number of the substituents is suitably one to three.

In the phthalocyanine compound represented by the general formula (I), examples of unsubstituted C₁₋₂₀ alkyl groups include linear, branched and cyclic alkyl groups, among which linear, branched and cyclic C₁₋₈ alkyl groups are preferable. Specific examples of unsubstituted C₁₋₈ alkyl groups include methyl, ethyl, n-propyl, isopropyl, n-butyl, isobutyl, sec-butyl, tert-butyl, n-pentyl, isopentyl and neopentyl groups and the like, among which methyl, ethyl, n-propyl, isopropyl and n-butyl groups are preferable. Examples of substituents optionally contained in a C₁₋₂₀ alkyl group include a halogen atom, alkoxyl, hydroxyalkoxyl, alkoxyalkoxyl, alkoxyl halide, nitro, amino and alkylamino groups and the like. The number of the substituents is suitably one to two.

In the phthalocyanine represented by the general formula (I), examples of halogen atoms include a fluorine, chlorine, bromine and iodine atoms, among which a chlorine atom is preferable.

In the phthalocyanine compound represented by the general formula (I), the nonmetal is any atom other than a metal atom and may be two hydrogen atoms. Examples of metals include iron, magnesium, nickel, cobalt, copper, palladium, zinc, vanadium, titanium, indium, tin and the like. Examples of metallic oxides include titanyl, vanadyl and the like. Examples of metallic halides include aluminum chloride, indium chloride, germanium chloride, tin chloride (II), tin chloride (IV), silicon chloride and the like. Preferably, a metal, metallic oxide or metallic halide is adopted. Specific examples include copper, zinc, cobalt, nickel, iron, vanadyl, titanyl, indium chloride and tin chloride (II), among which copper, vanadyl and zinc are preferable.

According to the present invention, the phthalocyanine compound represented by the general formula (I) is preferably a phthalocyanine compound having an absorption peak in the range of wavelengths of 750 nm to 1000 nm. More specifically, a combination of two or more selected from five phthalocyanine compounds having absorption peaks at wavelengths in the vicinity of 750 nm, 800 nm, 900 nm, 950 nm and 1000 nm, respectively, are preferable. For the purpose of blocking light in the infrared region in actual use, a combination of about four phthalocyanine compounds having absorption peaks in the range of wavelengths 800 nm to more are preferable. For the purpose of blocking light in the near-infrared region as well, a combination of about five phthalocyanine compounds including one having an absorption peak at a wavelength of 750 nm are more preferable. The proportion of each phthalocyanine compound is not particularly limited. When it is intended to evenly block light in the infrared region, the phthalocyanine compounds may be used in equivalent amounts, whereas when it is intended to block light having a particular wavelength, a phthalocyanine compounds having an absorption peak at the particular wavelength may be included among them in an increased amount.

The optical sensors (A) and (B) according to the present invention may further include a light-shielding frame that covers all the outer surfaces of the light-transmissive resin encapsulating portion except an outer surface on the side of a light-receiving surface of the photodetector. With the present invention constituted as above, the light-shielding frame covers all the side surfaces of the photodetector except the light-receiving surface thereof so that all light that enters the photodetector passes through the infrared-absorbing layer, resulting in an improved characteristic of blocking infrared radiation.

The transmittance of the light-transmissive resin encapsulating portion in the visible-light region may be substantially constant in the range of blue light (450 nm) to red light (650 nm). By being constituted as above, the present invention can realize the optical sensor showing the dependence on wavelength.

Also, in the optical sensors (A) and (B), as described above, it is preferable to employ two or more infrared-absorbing substances having absorption peaks at different wavelengths to obtain a characteristic of transmittance substantially flat in the visible-light region. More specifically, when the phthalocyanine compound having an absorption peak in the range of wavelengths of 750 nm to 1000 nm is used, the present invention can provide the optical sensor having a characteristic closer to the visibility of the human eye.

When a plurality of phthalocyanine dyes having absorption peaks at different wavelengths are used in combination with a sensitivity characteristic of a phototransistor (photodetector), the present invention can realize the optical sensor having a characteristic closer to the visibility of the human eye. Such an optical sensor has the advantage as follows. It can also be used, for example, for monitoring brightness and color shade of a white light source of a liquid-crystal backlight device or the like purpose. More specifically, when a semiconductor light-emitting device is used as a light source, the light-emission efficiency changes with time, and the output from the light-emitting device needs to be monitored to adjust the drive voltage thereof. More specifically, when a red semiconductor light-emitting device, a green semiconductor light-emitting device and a blue semiconductor light-emitting device are used to perform full-color display as in the liquid-crystal backlight device, such a problem comes up that the color shade changes as the light-emission intensity changes from its original state. When the visible-light sensor as described above is used as the optical sensor, the changes in shade can be monitored in the state as viewed by the human.

In the optical sensor according to the present invention, the photodetector is not particularly limited and may be, for example, a phototransistor, a photodiode or the like. More specifically, a photodetector having a peak sensitivity to light in the visible-light region is preferable, and for example, a Si phototransistor is preferable. As described above, the optical sensor of the present invention wherein the photodetector has a characteristic close to the visibility of the human eye has the advantage of being closer to the human vision.

According to the present invention, there is provided a process of producing the optical sensor (A), comprising the steps of: electrically connecting a photodetector to an electrode provided on a substrate; and forming a light-transmissive resin encapsulating portion on the substrate so that the photodetector is entirely encapsulated in the light-transmissive resin encapsulating portion, wherein the step of forming the light-transmissive resin encapsulating portion includes the step of forming an infrared-blocking layer either inside the light-transmissive resin encapsulating portion or on an outer surface of the light-transmissive resin encapsulating portion for blocking infrared radiation from the outside from reaching the photodetector.

According to the present invention, there is provided a process of producing the optical sensor (B), comprising the steps of: electrically connecting a photodetector to an electrode provided on a substrate; and forming a light-transmissive resin encapsulating portion on the substrate so that the photodetector is entirely encapsulated in the light-transmissive resin encapsulating portion, wherein in the step of forming the light-transmissive resin encapsulating portion, the light-transmissive resin encapsulating portion is formed of a tranparent resin containing an infrared-absorbing substance.

According to the process of producing the optical sensor (A) and the process of producing the optical sensor (B) of the present invention, the optical sensors (A) and (B) having improved characteristics can easily be produced at a low cost.

In the process of producing the optical sensor (A), the step of forming the infrared-blocking layer may include forming, on the outer surface of the light-transmissive resin encapsulating portion, either an infrared-absorbing layer containing an infrared-absorbing substance or an infrared-reflecting layer containing an infrared-reflecting substance. With this arrangement, the infrared-reflecting layer can easily be formed after the light-transmissive resin encapsulating portion is formed.

Also, in the process of producing the optical sensor (A), the step of forming the resin encapsulating portion may include the steps of: forming an inner resin portion for encapsulating the photodetector; forming the infrared-blocking layer for covering an outer surface of the inner resin portion with either an infrared-absorbing layer containing an infrared-absorbing substance or an infrared-reflecting layer containing an infrared-reflecting substance; and forming an outer resin portion for covering an outer surface of either the infrared-absorbing layer or the infrared-reflecting layer.

With this arrangement, the infrared-absorbing layer or the infrared-reflecting layer covers not only the light-receiving surface (upper surface) of the photodetector but also the side surfaces thereof, so that infrared radiation from the side surfaces of the transparent resin encapsulating portion can be blocked, resulting in an improved characteristic of blocking infrared radiation.

The process of producing the optical sensor (A) and the process of producing the optical sensor (B) according to the present invention may further comprise the step of forming a light-shielding frame for covering all the outer surface of the Tight-transmissive resin encapsulating portion except an outer surface thereof on a light-receiving surface side of the photodetector, the step of forming the light-shielding frame being carried out before the step of forming the resin encapsulating portion. With this arrangement, the light-shielding frame prevents light from reaching all the surfaces of the photodetector except the light-receiving surface thereof, so that all light to enter the photodetector is blocked by either the infrared radiation absorbing layer or the infrared radiation reflecting layer, resulting in an improved characteristic of blocking infrared radiation.

Also, the step of forming the resin encapsulating portion may comprise: holding the substrate, having a plurality of said photodetectors mounted thereon, between an upper mold and a lower mold, the upper mold having, in correspondence with the photodetectors, a plurality of recesses to be used for formation of the light-transmissive resin encapsulating portion; pouring a light-transmissive resin into the recesses inside the mold; and then curing the resin thereby to form the resin encapsulating portions. With this arrangement, the optical sensors excellent in characteristic of blocking infrared radiation can be mass-produced.

In another aspect, the present invention provides a light-transmissive resin composition to be used both for an optical sensor filter and for encapsulating a photodetector of an optical sensor, the light-transmissive resin composition having an infrared radiation blockage function provided by addition of a plurality of phthalocyanine dyes as infrared-absorbing substances to a light-transmissive resin.

Hereinafter, specific embodiments of the present invention will be explained in detail with reference to the drawings. However, the present invention is not limited to these embodiments.

### [Embodiment 1]

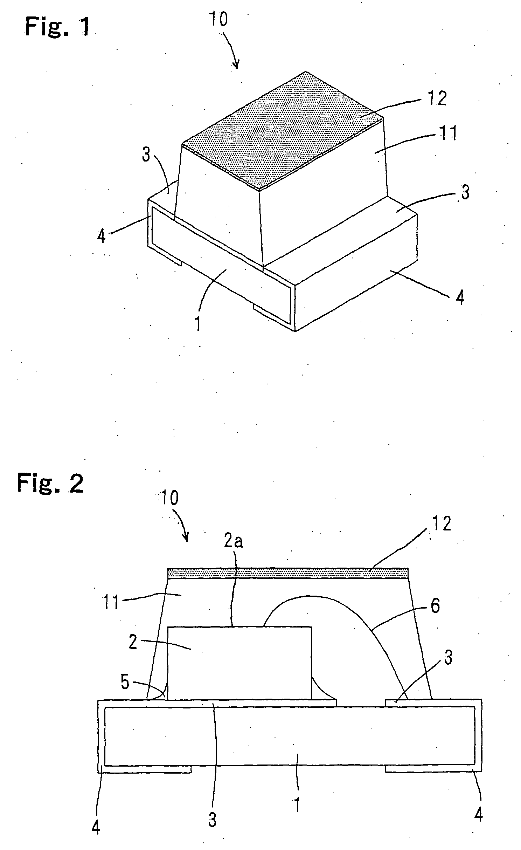

Fig. 1 is a perspective view showing an optical sensor according to Embodiment 1 of the present invention; and Fig. 2 is a front view in section showing the optical sensor according to Embodiment 1.

An optical sensor 10 according to Embodiment 1 includes: a substrate 1 having, on a mounting surface thereof, a pair of electrodes (metal pad portions) 3 of opposite polarity; a photodetector 2 electrically connected to the electrodes 3 on the substrate 1; and a light-transmissive resin encapsulating portion 11 for encapsulating the photodetector 2 on the substrate 1; and an infrared-absorbing layer 12 formed on an outer surface of the light-transmissive resin encapsulating portion 11, the infrared-absorbing layer 12 serving as an infrared-blocking layer that is.

The substrate 1 is made of, for example, glass or an epoxy resin, and shaped in a rectangular plate. The pair of electrodes 3,3 are of opposite polarity and formed at the opposite sides on a mounting surface of the substrate 1. On the substrate 1, there are also formed a pair of terminal electrodes 4,4 joined to the pair of electrodes 3,3, respectively, and extending along the opposite side surfaces of the substrate 1 and further along a rear surface thereof.

The photodetector 2 is shaped in a rectangular block and is, for example, a phototransistor, a photodiode or the like. The photodetector 2 has an electrode portion on a light-receiving surface 2a side and another electrode portion on the side opposite to the light-receiving surface 2a. The electrode portion on the side opposite to the light-receiving surface 2a is electrically connected via a conductive adhesive 5 to one of the electrodes 3 on the substrate 1. The electrode portion on the light-receiving surface 2a side is electrically connected via a small-gage metal wire 6 to the other electrode 3 on the substrate 1.

The photodetector 2 to be used in the present invention is not particularly limited, may be a phototransistor, a photodiode or the like as described above, and is preferably, a Si phototransistor, a Si photodiode or the like, having a peak sensitivity in the visible-light region. This will be explained later.

The light-transmissive resin encapsulating portion 11 is made of, for example, an epoxy resin having insulating, light-transmissive and thermosetting properties, shaped in a substantially rectangular solid, and covers the photodetector 2 and the small-gage metal wire 6.

The infrared-absorbing layer 12 for blocking infrared radiation from the outside from reaching the photodetector is made of an infrared-absorbing film and bonded to an upper surface of the light-transmissive resin encapsulating portion 11 by means of a transparent adhesive. The infrared-absorbing film is obtained by forming a transparent resin (e.g., epoxy resin) containing, for example, infrared-absorbing substances into a film having a thickness of 20 µm to 100 µm.

As the infrared-absorbing substances, two or more infrared-absorbing dyes having different absorption peak sensitivities and spectral transmittances are used in combination since it is difficult to block (absorb) infrared radiation in a wide range by the use of only one infrared-absorbing dye. By the optimal use of a number of infrared-absorbing dyes having different absorption peak sensitivities and spectral transmittances, the target characteristic of blocking infrared radiation in a wide range can be obtained.

An explanation will be given taking, for example, four infrared-absorbing dyes having absorption peaks at different wavelengths.

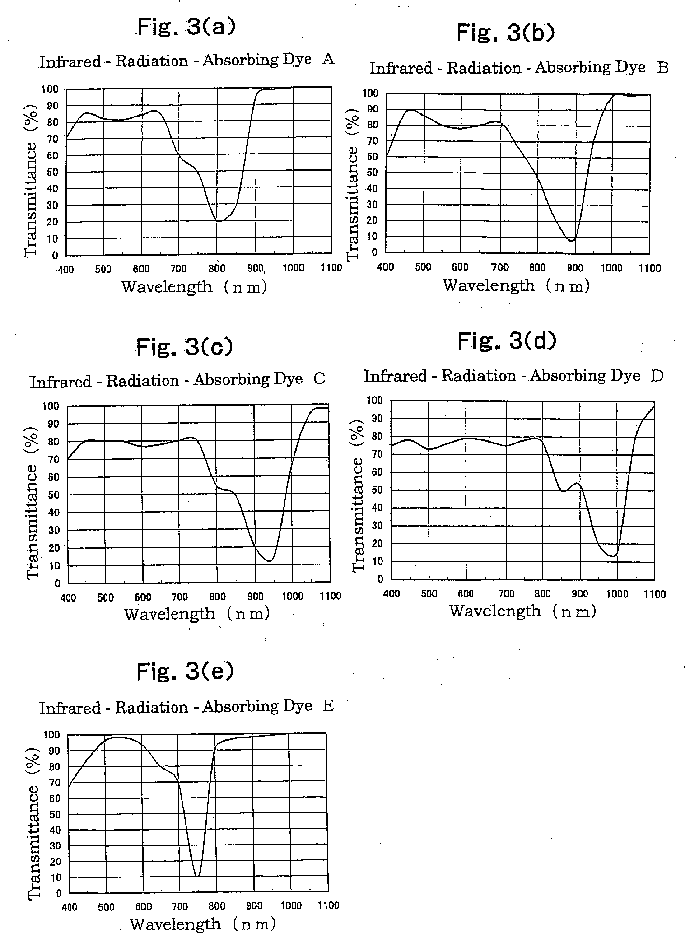

Figs. 3 are graphs showing relationships the infrared-absorbing dyes have between an absorption peak sensitivity and a spectral transmittance.. Fig. 3(a) is a graph of an infrared-absorbing dye A; Fig. 3(b) is a graph of an infrared-absorbing dye B; Fig. 3(c) is a graph of an infrared-absorbing dye C; and Fig. 3(d) is a graph of an infrared-absorbing dye D. These graphs show that the infrared-absorbing dyes A, B, C and D have absorption peaks at wavelengths in the vicinity of 800 nm, 900 nm, 950 nm, 1000 nm, respectively.

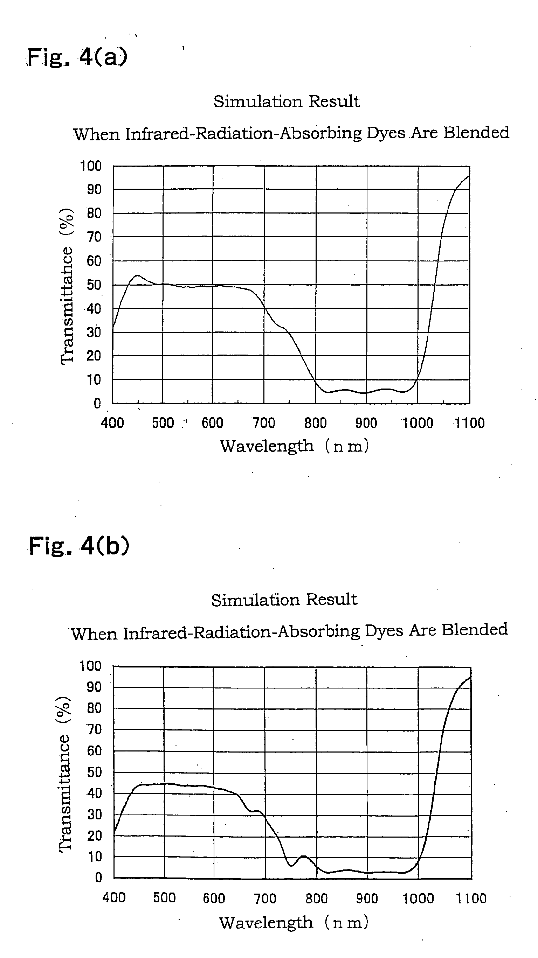

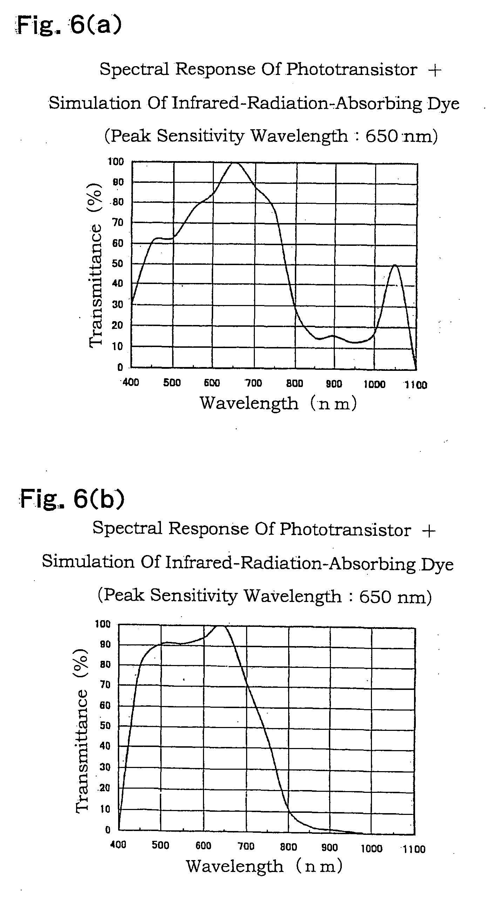

For example, when it is intended to block infrared radiation having wavelengths longer than 800 nm, the infrared-absorbing dyes A, B, C and D are used together in optimal proportions to make substantially constant the transmittance in the range of the wavelengths of 450 nm to 650 nm as shown by the simulation result in Fig. 4(a). When a light-transmissive resin containing these infrared-absorbing substances is used to encapsulate photodetectors made of Si phototransistors having phototransistor spectral response characteristics shown in Figs. 5(a) and 5(b), optical sensors showing the dependences of sensitivity on wavelength as shown in Figs. 6(a) and 6(b) can be obtained. That is, the simulation result obtained when a conventional photodetector of Fig. 5(a) is used is shown in Fig. 6(a). The peak sensitivity wavelength is 650 nm and thus slightly longer than the wavelength of 555 nm at which the peak of the visibility is located, though the sensitivity at a wavelength of 800 nm is less than 30 % of the sensitivity at the peak wavelength, which means that the optical sensor of Fig. 6(a) can block infrared radiation to a certain extent. Also, the optical sensor of Fig. 6(a), which employs the phototransistor of Fig. 5(a) having a peak sensitivity at a wavelength of 900 nm, shows a rise in the transmittance in the range of wavelengths of 1000 nm to longer (has a small peak in sensitivity at 1050 nm). The rise, however, does not constitute any problem in actual use of the optical sensor because the Si phototransistor does not have any sensitivity to light in the above range of wavelengths. In the optical sensor of Fig. 6(b), on the other hand, the sensitivity at a wavelength of 800 nm is lower, that is, less than 10% of the sensitivity at the peak wavelength, which means that the optical sensor of Fig. 6(b) can block, at an increased rate, infrared radiation in the range of wavelengths of 800 nm to longer.

Fig. 6(e) shows another case. Fig. 6(e) is a graph of an infrared-absorbing dye E having an absorption peak at a wavelength of 750 nm. When the infrared-absorbing dyes A to E are used together in optimal proportions, the simulation result shown in Fig. 4(b) can be obtained'.

Comparison between the simulation results of Figs. 4(a) and 4(b) indicates that, in both the simulation results, the transmittance is substantially constant in the range of wavelengths of 450 nm to 650 nm. In the simulation result of Fig. 4(b), on the other hand, the transmittance of infrared radiation having wavelengths longer than 750 nm is substantially 20% or less of the peak, which means that when the infrared-absorbing dyes A to E are used together in optimal proportions, the optical sensor has a characteristic closer to the visibility of the human eye.

The optical sensor according to Embodiment 1 employs as the infrared-absorbing substances the phthalocyanine-based dyes, which are organic dyes, so that it is ensured that the light-transmissive resin that contains the phthalocyanine-based dyes and that constitutes the infrared-absorbing layer 12 is substantially the same in linear expansion coefficient as the molding resin that constitutes the light-transmissive resin encapsulating portion 11. Therefore, a conventional resin-molding technique can be employed in the production of the optical sensor of Embodiment 1.

Next, an explanation will be given on a peak sensitivity of the photodetector 2. Figs. 5 are graphs showing different spectral response characteristics of two Si phototransistors. When a peak sensitivity and a spectral response characteristic of the optical sensor of Embodiment 1 are close to the characteristics of the visible light, especially to the characteristics of the human eye visibility, and thus the vision of the optical sensor is closer to the human vision, the optical sensor becomes an effective device in blocking infrared radiation. Because typical photodetectors are used in combination with infrared radiation (an infrared LED), many have a peak sensitivity at a wavelength of about 900 nm. One example is a photodetector (phototransistor) having a spectral response characteristic as shown in Fig. 5(a). An optical sensor of the type that detects light in the environment, for example, solar radiation and light from lighting fixtures such as a fluorescent lamp and a light bulb is suitably a photodetector having a sensitivity to visible light (about 380 nm to 800 nm). One preferable example is a photodetector (phototransistor) having a spectral response characteristic: the peak sensitivity is at a wavelength of about 650 nm, as shown in Fig. 5(b). A photodetector suitable for blocking infrared radiation is again the photodetector having a peak sensitivity in the visible-light region. When employing the photodetector having a peak sensitivity at a wavelength of about 650 nm as shown in the simulation result on the spectral response characteristic in Fig. 6(b), the optical sensor has an improved characteristic of blocking infrared radiation.

As well known, the phototransistor as described above can be realized by changing the depth of a pn junction created by diffusing B (boron) or the like in an n-type Si semiconductor substrate. When the depth of diffusion is sufficiently great, the photodetector obtained has a wavelength sensitivity upon which the absorption characteristic of Si is reflected as shown in Fig. 5(a). As the depth of diffusion is made shallower, the photodetector obtained has a peak sensitivity shifted toward the visible-light region as shown in Fig. 5(b). When the depth of diffusion is made too shallow, however, the withstand voltage is reduced to make the use of the optical sensor impractical. Currently, the limit of the peak sensitivity wavelength is about 650 nm as shown in Fig. 5(b).

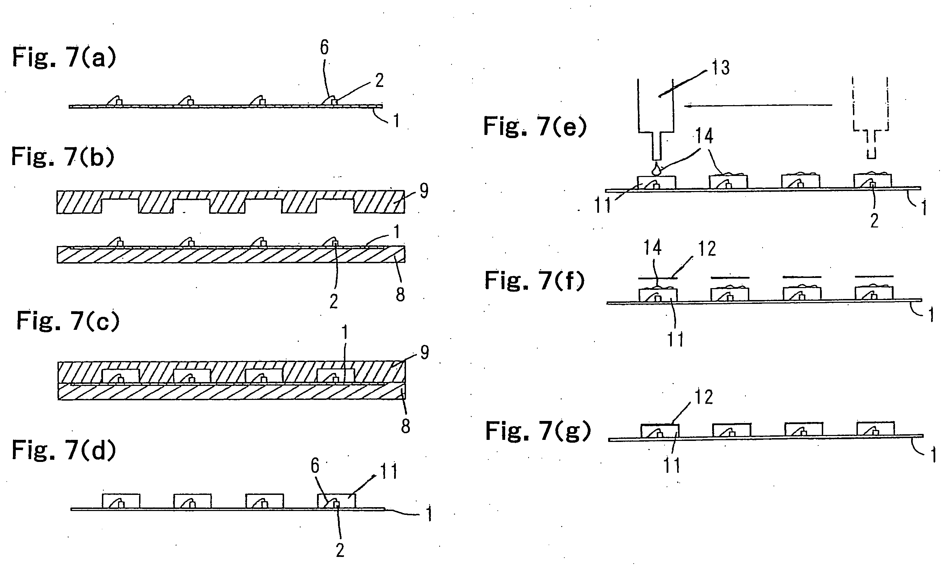

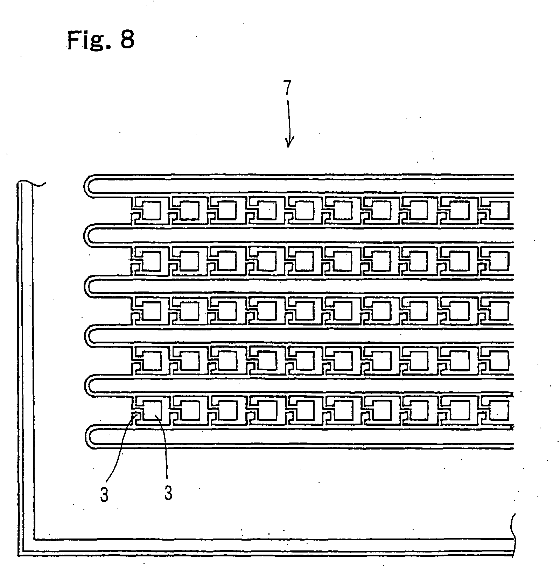

Next, with reference to Figs. 7 and 8, there will be explained a process of producing the optical sensor 10 of Embodiment 1 which has been explained with reference to Figs. 1 and 2. Figs. 7 are a flowchart showing the step of forming the resin encapsulating portion in the production of the optical sensor of Embodiment 1; and Fig. 8 is a partial plan view showing one example of an electrode (metal wiring) pattern to be used in the production of the optical sensor of Embodiment 1.

The process of producing the optical sensor of Embodiment 1 includes the steps of: electrically connecting the photodetector 2 to the electrode 3 provide on the substrate 1; and forming the light-transmissive resin encapsulating portion 11 on the substrate 1 so that the light-transmissive resin encapsulating portion 11 entirely encapsulates the photodetector 2. In the step of electrically connecting the photodetector to the electrodes, a plurality of said photodetectors 2 are mounted, via the conductive adhesive 5, on the electrodes 3 arranged in an electrode pattern 7 as shown in Fig. 8, and are electrically connected to the electrodes 3. Detailed explanations are omitted since this step is carried out by the same known technique as employed conventionally. The electrode pattern 7 shown in Fig. 8 is merely an example, and the wiring pattern may be designed arbitrarily so that it does not interfere with the steps to be carried out later.

Fig. 7(a) shows a state wherein the plurality of photodetectors 2 are mounted on the electrodes on the substrate 1 and electrically connected thereto. In the step of forming the light-transmissive resin encapsulating portion, first, as shown in Fig. 7(b), the substrate 1, having the plurality of photodetectors 2 mounted thereon, is set in a lower mold 8, then as shown in Fig. 7(c), the substrate 1 is held and fixed between an upper mold 9 and the lower mold 8 under conditions where no resin leakage, substrate fracture or the like will occur, and a resin is transfer-molded under heating at about 150°C. The upper mold 9 has, in a lower surface thereof, substantially rectangular recesses to be used for formation of the encapsulating portions. However, since the shape of the recess decides the shape of the encapsulating portion, the recess may be designed arbitrarily as long as the recess allows the encapsulating portion to have a flat upper surface. When the molds are separated from each other after the resin is cured, it is found that as shown in Fig. 7(d), the photodetectors 2 and the small-gage metal wires 6 on the substrate 1 are encapsulated in the transparent resin encapsulating portions 11.

Next, in the step of forming the resin encapsulating portion, the infrared-absorbing layer 12 for blocking infrared radiation from the outside from reaching the photodetector 2 is formed on an outer surface of the light-transmissive resin encapsulating portion 11. More specifically, as shown in Fig. 7(e), a light-transmissive adhesive 14 is applied by using a dispenser 13 or the like to the upper surface of the transparent resin encapsulating portion 11, and then, as shown in Fig. 7(f), the infrared-absorbing film serving as the infrared-absorbing layer 12 is bonded to the upper surface of the transparent resin encapsulating portion. Thus, there is obtained a molded resin part having the infrared-absorbing layer 12 on the upper surface of the light-transmissive resin encapsulating portion 11. After that, the substrate is sectioned using a dicing blade or the like to separate the molded resin parts from one another on a product-by-product basis. Thus, the individual optical sensors are completed as products.

In the optical sensor 10 according to Embodiment 1, the product has the function of absorbing infrared radiation incorporated therein, so that it is possible to save time and effort to incorporate an infrared-blocking filter separately from the optical sensor. Also, by using the photodetector 2 having a peak sensitivity in the visible-light region, control can be made on a criterion closer to the one applied by the human eye. Also, in the process of producing the optical sensor 10 according to the present invention, only by adding the step of bonding the infrared-absorbing film serving as the infrared-absorbing layer 12 to the upper surface of the transparent resin encapsulating portion 11, it is possible to easily produce the optical sensor having the infrared radiation blockage function.

### [Embodiment 2]

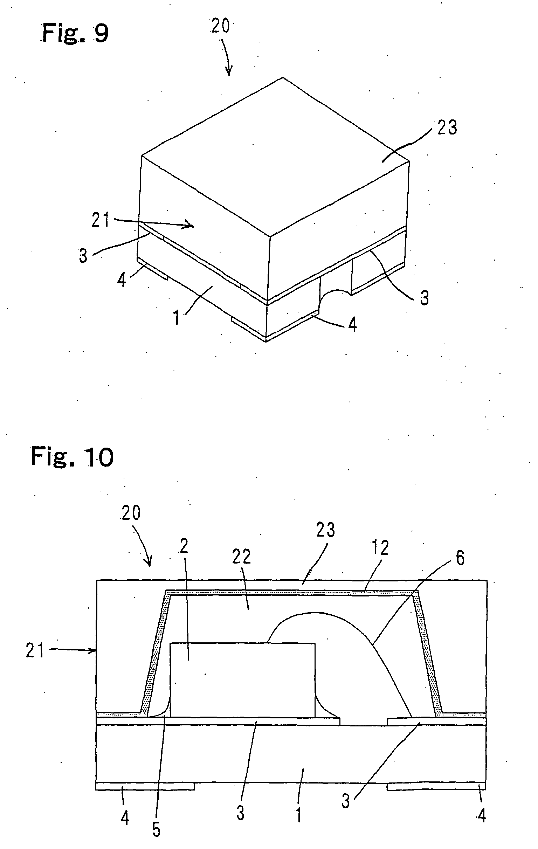

Fig. 9 is a perspective view of an optical sensor according to Embodiment 2 of the present invention; and Fig. 10 is a front view in section showing the optical sensor according to Embodiment 2.

In an optical sensor 20 according to Embodiment 2, a light-transmissive resin encapsulating portion 21 has an inner resin portion 22 and an outer resin portion 23, the inner resin portion 22 encapsulating the photodetector 2, the outer resin portion 23 covering the inner resin portion 22. The infrared-absorbing layer 12 is made of an infrared-absorbing film interposed between the inner resin portion 22 and the outer resin portion 23.. Like reference numerals denote like parts in Embodiment 1 and explanations thereon are omitted.

The inner resin portion 22 is made of, for example, an epoxy resin having insulating, light-transmissive and thermosetting properties. The outer resin portion 23 is made of, for example, an epoxy resin having light-transmissive and thermosetting properties. The inner resin portion 22 and outer resin portion 23 may be made of the same or different resins.

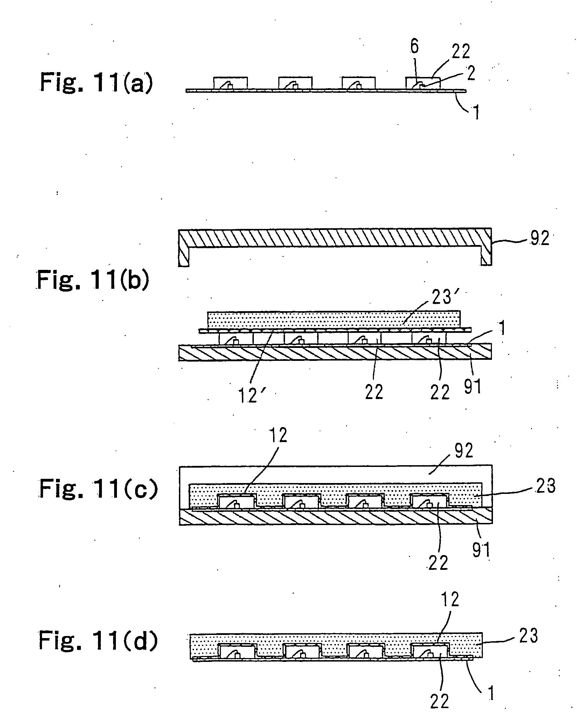

A process of producing the optical sensor 20 of Embodiment 2 will be explained with reference to a flowchart of Fig. 11 showing the step of forming the resin encapsulating portion in the production of the optical sensor.

In the step of forming the resin encapsulating portion according to Embodiment 2, first, there is carried out as shown in Fig. 11(a) the step of forming the inner resin portions on the substrate 1, having the plurality of photodetectors 2 mounted thereon, so that the inner resin portions 22 cover the photodetectors 2, respectively. The step of forming the inner resin portions is carried out in the same manner as in Embodiment 1 shown in Figs. 7(a) to 7(c). Next, as shown in Fig. 11(b), the substrate 1 is set in a lower mold 91, then an infrared-absorbing-layer formation film 12' is placed on the inner resin portion 22 on the substrate 1, and then a sheet resin 23' of B stage type, a type of resin having a high light-transmittance and having been cured midway, is placed on the infrared-absorbing-layer formation film 12'. After that, hot pressing with an upper mold 92 and the lower mold 91 is carried out, as shown in Fig. 11(c). Thus, there is obtained a molded resin part wherein all the outer surfaces of each inner resin portion 22 are covered with the infrared-absorbing layer 12 and wherein all the outer surfaces of the infrared-absorbing layer 12 are covered with the outer resin portion 23, as shown in Fig. 11(d). After that, the substrate is sectioned using the dicing blade or the like to separate the molded resin parts from one another on a product-by-product basis. Thus, the individual optical sensors 20 are completed as products.

In the optical sensor 20 according to Embodiment 2, not only the light-receiving surface (upper surface) of the photodetector 2 but also the side surfaces thereof are covered with the infrared-absorbing layer 12, so that infrared radiation to enter the transparent resin encapsulating portion 21 also from the side surfaces thereof can be blocked. Thus, the optical sensor has an improved characteristic of blocking infrared radiation in addition to the same effect as obtained in Embodiment 1. In the process of producing the optical sensor 20, the infrared-absorbing layer 12 and the outer resin portion 23 can be formed in one step efficiently.

### [Embodiment 3]

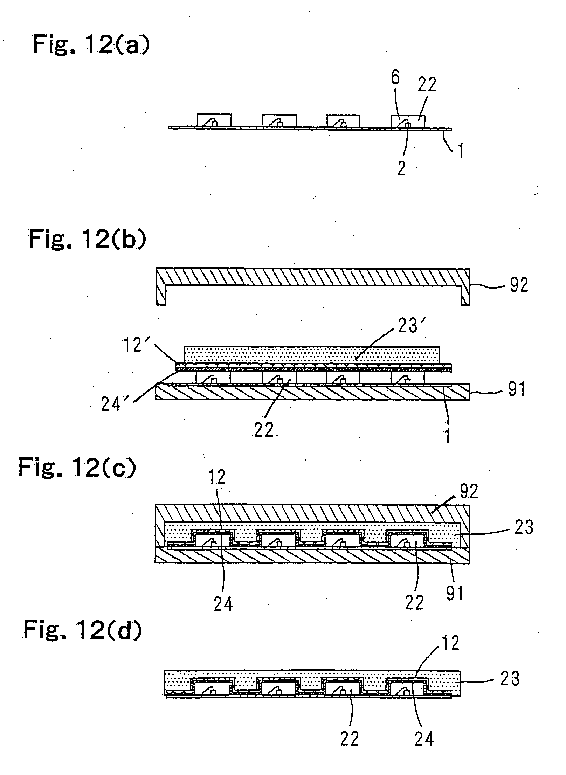

Figs. 12 are a flowchart showing the step of forming the resin encapsulating portions in the production of an optical sensor according to Embodiment 3 of the present invention.

In the optical sensor according to Embodiment 3, a transparent adhesive layer 24 is interposed between the transparent resin encapsulating portion 21 and the infrared-absorbing layer 12, of Embodiment 2. A process of producing the optical sensor according to Embodiment 3 will be explained as follows. In the step of forming the resin encapsulating portion, the substrate 1 on which as shown in Fig. 12 (a), the inner resin portions 22 are mounted to cover the plurality of photodetectors 2, respectively, is set in the lower mold 91, as shown in Fig. 12(b). Next, a transparent-adhesive-layer formation film 24' having heat resistance is placed on the inner resin portions 22 on the substrate 1, then the infrared-absorbing-layer formation film 12' is placed on the transparent-adhesive-layer formation film 24' having heat resistance, and the sheet resin 23' of B stage type, a type of resin having a high light-transmittance and having been cured midway, is placed on the infrared-absorbing-layer formation film 12'. After that, hot pressing with an upper mold 92 and the lower mold 91 is carried out, as shown in Fig. 12(c). Thus, there is obtained a molded resin part wherein all the outer surfaces of the inner resin portion 22 are covered with the infrared-absorbing layer 12 and wherein all the outer surfaces of the infrared-absorbing layer 12 are covered with the outer resin portion 23, as shown in Fig. 12 (d). After that, the substrate is sectioned using a dicing blade or the like, in the same manner as described above. Thus, the individual optical sensors are completed as products.

With the optical sensor constituted as above, an improved contact is established between the inner resin portion 22 and the infrared-absorbing layer 12.

### [Embodiment 4]

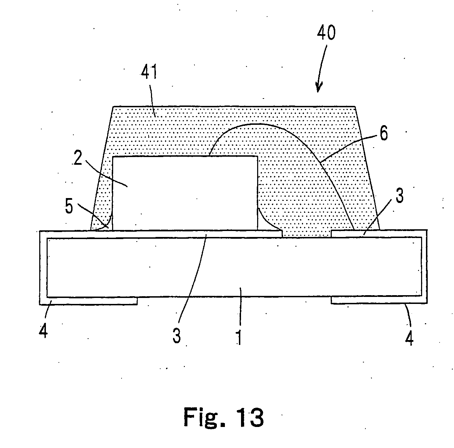

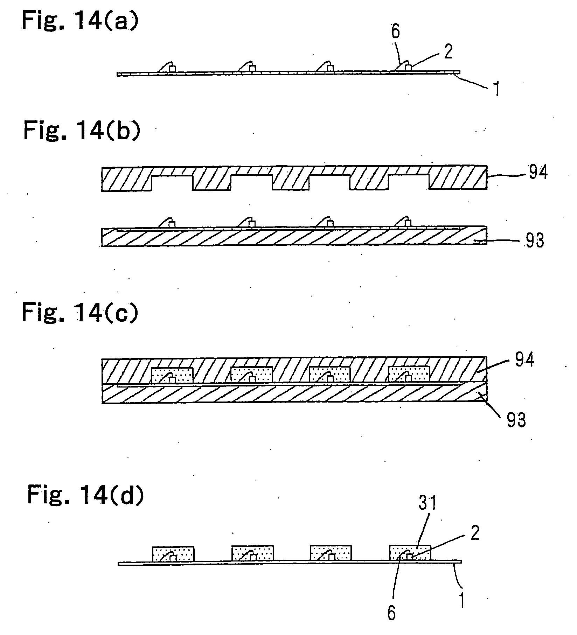

Fig. 13 is a front view in section of an optical sensor according to Embodiment 4 of the present invention; and Figs. 14 are a flowchart showing the step of forming the resin encapsulating portion in the production of the optical sensor according to Embodiment 4.

In the optical sensor according to Embodiment 4, a light-transmissive resin encapsulating portion 41 contains infrared-absorbing substances. Like reference numerals denote like parts in Embodiment 1 and explanations thereon are omitted.

The light-transmissive resin encapsulating portion 31 contains a mixture of predetermined amounts of two or more infrared-absorbing dyes and a resin (e.g., epoxy resin) having insulating, light-transmissive and thermosetting properties.

There will be explained the transparent resin encapsulating portion 41 having the function of absorbing infrared radiation.

Table 1 shows the results of measurements on the characteristics of an optical sensor obtained by varying the proportion of the infrared-absorbing dyes to the transparent resin in stages in the range of 0 wt% to 0.1 wt%. The results in Table 1 are experimental results obtained on the product of a large size (3.5 mm X 2.8 mm X 1.9 mm (thickness)). It is necessary to vary the proportion depending on the product size. The proportion, in the case where only one infrared-absorbing dye is used., refers to the proportion of the one infrared-absorbing dye to the light-transmissive resin, while in the case of a plurality of dyes are used, the proportion refers to the proportion of all the dyes to the transparent resin.

**[Table 1]**

| Relationship between Amount of Infrared-Absorbing Dyes to be Added and Characteristics of Optical Sensor | | | |
|---|---|---|---|
| Amount of Dyes to be Added (wt%) | Photocurrent (*µ*A) | Light Transmittance (%) | Peak Wavelength of Light Receiving Sensitivity (nm) |
| 0 | 1.796 | 66.7 | 590 |
| 0.10 | 0.951 | 47.6 | 590 |
| 0.30 | 0.471 | 30.5 | 580 |
| 0.40 | 0.268 | 18.5 | 570 |
| 1.00 | 0.138 | 8.5 | 570 |

As seen from Table 1, as the proportion of the infrared-absorbing dyes is raised (the amount of the dyes to be added is increased), the transmittance declines, the photocurrent output from the optical sensor decreases, and the light receiving sensitivity of the optical sensor lessens. On the other hand, the rate of blockage of infrared radiation having a wavelength of 770 nm, slightly shorter than 800 nm, increases as the proportion of the infrared-absorbing dye(s) is raised. This indicates that the absorption by the dyes is not saturated in the above range of proportions. Also, the transmittance slightly changes. As the proportion of the dyes to be added is increased, the peak wavelength of light receiving sensitivity shortens, i.e., the peak shifts toward a wavelength of 550 nm, a desirable peak wavelength.

Accordingly, when the proportion of the infrared-absorbing dyes to the resin is adjusted, there can be obtained the optical sensor having desired characteristics as shown in Figs. 4(a) and 4(b).

Next, a process of producing an optical sensor 40 according to Embodiment 4 will be explained with reference to Figs. 14.

In the step of forming the light-transmissive resin encapsulating portion according to Embodiment 4, the substrate 1, having the plurality of photodetectors 2 mounted thereon, as shown in Fig. 14(a) is set in a lower mold 93, as shown in Fig. 14(b). Next, the substrate 1 is held and fixed between an upper mold 94 and the lower mold 93 under conditions where no resin leakage, substrate fracture or the like will occur, and the transparent resin containing the infrared-absorbing dyes is transfer-molded. When the molds are separated from each other after the resin is cured, it is found that the photodetectors 21 and the small-gage metal wires 6 on the substrate 1 are encapsulated in the transparent resin encapsulating portions 31 that also serves as the infrared-blocking layer, as shown in Fig. 14(d). After that, the substrate is sectioned in the same manner as described above. Thus, the individual optical sensors are completed as products.

In the optical sensor 40 according to Embodiment 4, the photodetector 2 is entirely encapsulated in the transparent resin encapsulating portion 31 having the function of absorbing infrared radiation, so that infrared radiation to enter the transparent resin encapsulating portion 31 from every angle can be blocked. Thus, the optical sensor has an improved characteristic of blocking infrared radiation in addition to the same effect as obtained in Embodiment 1. In the process of producing the optical sensor 40, the transparent resin encapsulating portion 31 and the infrared-absorbing layer can be formed in one step without an increase in the number of manufacturing steps.

### [Embodiment 5]

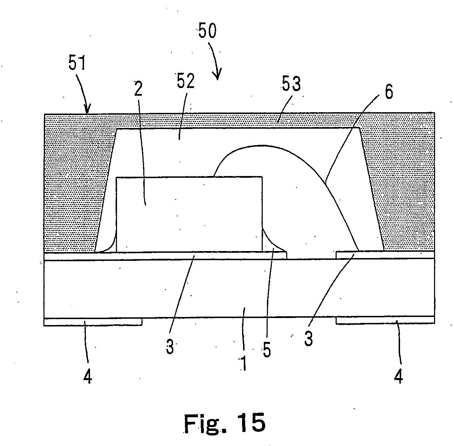

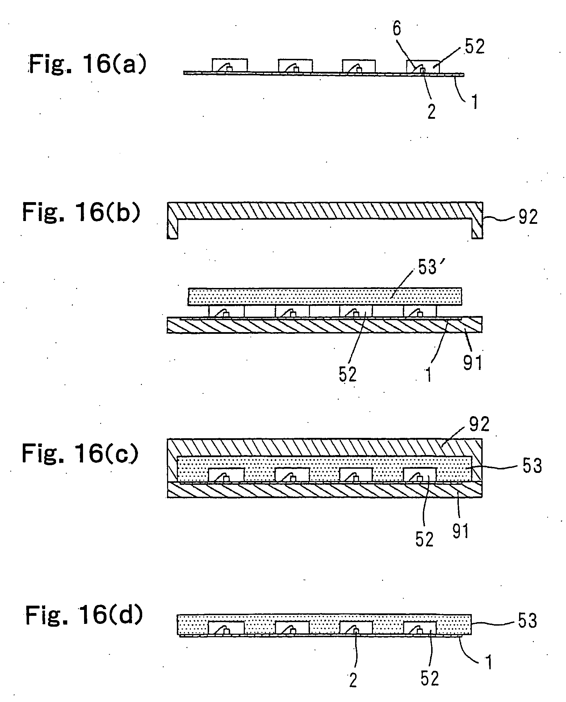

Fig. 15 is a front view in section of an optical sensor according to Embodiment 5 of the present invention; and Figs. 16 are a flowchart showing the step of forming the resin encapsulating portion in the production of the optical sensor according to Embodiment 5.

In the optical sensor 50 according to Embodiment 5, an infrared-absorbing layer 53 is formed on an outer surface of a light-transmissive resin encapsulating portion 51 and serves also as an outer resin portion. The light-transmissive resin encapsulating portion 51 includes an inner resin portion 52 and an outer resin portion. The inner resin portion 52 encapsulates the photodetector and made of a resin having insulating, light-transmissive and thermosetting properties. The outer resin portion covers the inner resin portion 52. The outer resin portion is made of a mixture of two or more of infrared-absorbing dyes and a resin having light-transmissive and thermosetting properties and has the function of absorbing infrared radiation. Like reference numerals denote like parts in Embodiment 1 and explanations thereon are omitted.

Next, a process of producing the optical sensor 50 according to Embodiment 5 will be explained with reference to the flowchart of Figs. 16.

In the step of forming the light-transmissive resin encapsulating portion according to Embodiment 5, the substrate 1 on which as shown in Fig. 16(a), the inner resin portions 22 are mounted to cover the plurality of photodetectors 2, respectively, is set in the lower mold 91 as shown in Fig. 16(b). Then, a sheet resin 53', containing two or more infrared-absorbing dyes, of B stage type, a type of resin having a high light-transmittance and having been cured midway, is placed on the inner resin portions 52 on the substrate 1. After that, hot pressing with an upper mold 9.2 and the lower mold 91 is carried out, as shown in Fig. 16(c). Thus, as shown in Fig. 16(d), there is obtained a molded resin part wherein all the outer surfaces of the inner resin portion 52 are covered with the infrared-absorbing layer 53. Then, the substrate is sectioned to complete the individual optical sensors 20 as products.

In the optical sensor 50 according to Embodiment 5, the photodetector 2 is entirely covered with the outer resin portion that serves also as the infrared-absorbing layer 53 so that infrared radiation entering the outer resin portion (infrared-absorbing layer 53) from every angle can be blocked. Thus, the optical sensor has an improved characteristic of blocking infrared radiation in addition to the same effect as obtained in Embodiment 1. In the process of producing the optical sensor 50, the infrared-absorbing layer 53 and the outer resin portion can be formed simultaneously in one step efficiently.

### [Embodiment 6]

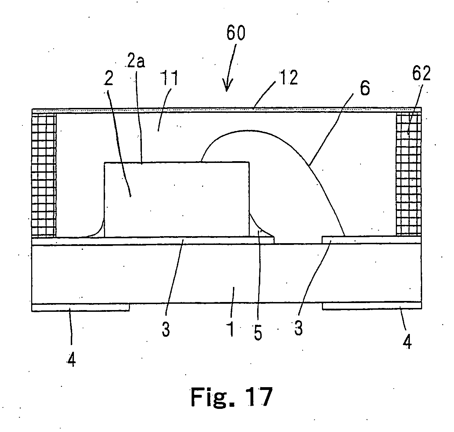

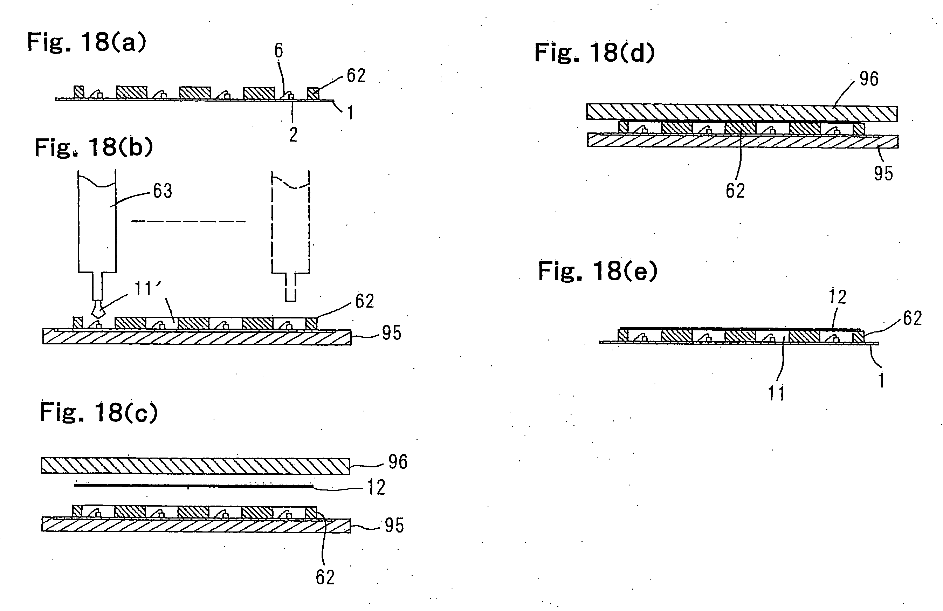

Fig. 17 is a front view in section of an optical sensor according to Embodiment 6 of the present invention; and Figs. 18 are a flowchart showing the step of forming the resin encapsulating portion in the production of the optical sensor according to Embodiment 6.

The optical sensor 60 according to Embodiment 5 includes, in addition to the components recited in Embodiment 1, a light-shielding frame 62 having a light-shielding property. The light-shielding frame 62 covers all the outer surfaces of the light-transmissive resin encapsulating portion 11 except an outer surface thereof on the light-receiving surface 2a side of the photodetector 2. The light-shielding portion 62 is made of, for example, a black-colored resin, shaped in a hollow square when viewed from the top, and is formed on the substrate 1 in a close contact with the four outer surfaces of the light-transmissive resin encapsulating portion 11. Like reference numerals denote like parts in Embodiment 1 and explanations thereon are omitted.

A process of producing the optical sensor 60 according to Embodiment 6 will be explained with reference to a flowchart of Fig. 18.

Fig. 18(a) shows the substrate 1 having the light-shielding frames 62 provided around the plurality of photodetectors 2, respectively. The photodetectors 2 are mounted on the electrodes 3 arranged in the electrode pattern 7 of Fig. 8. The light-shielding frames 62 are bonded in advance to the electrodes 3. In the step of forming the light-transmissive resin encapsulating portion according to Embodiment 6, the substrate 1 having the light-shielding portion 62 is set in a lower mold 95 and then, a light-transmissive resin encapsulating portion formation resin 11' is injected by using a dispenser 63 into each light-shielding frame 62 to the brim, as shown in Fig. 18(b). After that, as shown in Fig. 18(c), the infrared-absorbing film as the infrared-blocking layer 12 is placed on the light-shielding frames 62.. Then, as shown in Fig. 18(d), the substrate 1 is held and fixed between an upper flat mold 96 and a lower mold 95 under conditions where no resin leakage, substrate fracture or the like will occur. Then, heat curing is carried out by means of an oven or the like to obtain a molded resin part as shown in Fig. 18(e). Then, the substrate is sectioned to complete the individual optical sensors 60 as products.

In the optical sensor 60 according to Embodiment 6, the light-shielding frame 62 covers all the side surfaces of the photodetector 2 except the light-receiving surface 2a so that all light that enters the photodetector 2 passes through the infrared-absorbing layer 12 to ensure that the optical sensor has an improved characteristic of blocking infrared radiation in addition to the same effect as obtained in Embodiment 1. In the process of producing the optical sensor 60, the light-shielding frame 62 serves as a frame for use in the formation the transparent resin encapsulating portion 11 so that the need to use the upper mold illustrated in Fig. 7 of Embodiment 1 is eliminated.

### [Embodiment 7]

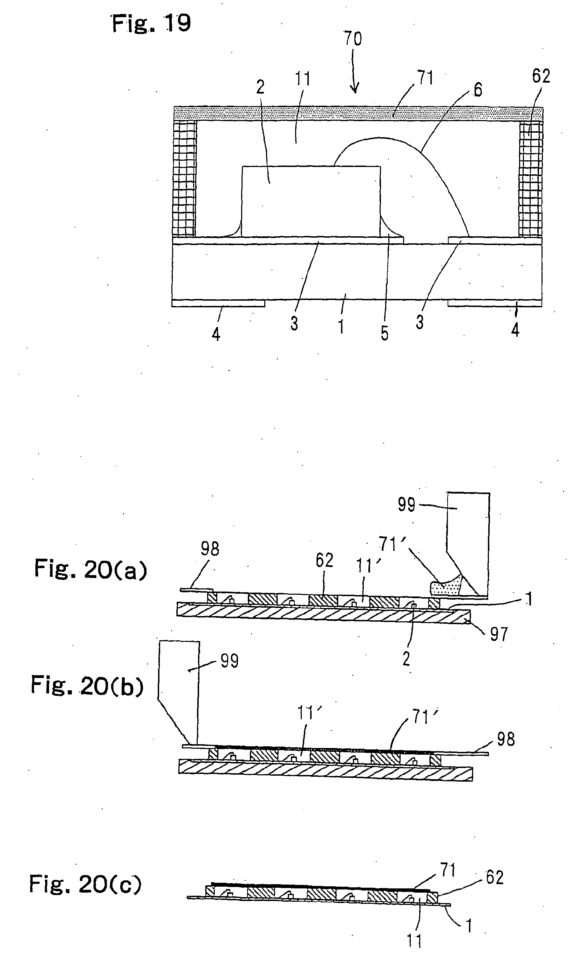

Fig. 19 is a front view in section of an optical sensor according to Embodiment 7 of the present invention; and Fig. 20 is a flowchart showing the step of forming the resin encapsulating portions in the production of the optical sensor according to Embodiment 7.

In Embodiment 7, the infrared-absorbing layer 12 as the infrared-absorbing film in Embodiment 6 is replaced by an infrared-absorbing layer 71 as a transparent-resin layer containing infrared-absorbing dye(s). Like reference numerals denote like parts in Embodiment 1 and explanations thereon are omitted.

A process of producing the optical sensor 70 according to Embodiment 7 is as follows. First, the transparent resin 11' having a heat curing property is injected into the light-shielding frame 62 in the same manner as shown in Fig. 18(b) of Embodiment 6. Next, as shown in Fig. 20(a), the substrate 1 is set in a printing stage 97; a metal mask 98 having an aperture is set on the light-shielding frames 62; and a mass of a light-transmissive resin 71' having a heat curing property is put on one side of the metal mask 98. The resin 71' is in the form of a gel and contains infrared-absorbing dyes. After that, as shown in Fig. 20(b), a squeegee 99 is moved so that the resin 71' is poured into the aperture of the metal mask 98. Next, the resin 71' is heat-cured by means of an oven without the mask 98 as shown in Fig. 20(c) to form the transparent resin encapsulating portions 11 and the infrared-absorbing layer 71. Then, the substrate is sectioned to complete the individual optical sensors 70 as products.

In the optical sensor 70 according to Embodiment 7, the light-shielding frame 62 covers all the side surfaces of the photodetector 2 except the light-receiving surface 2a so that all light that enters the photodetector 2 passes through the infrared-absorbing layer 12 to ensure that the optical sensor has an improved characteristic of blocking infrared radiation in addition to the same effect as obtained in Embodiment 1. In the process of producing the optical sensor 70, the light-shielding frame 62 serves as a frame for use in the formation the transparent resin encapsulating portion 11. Therefore, the need to use the upper mold illustrated in Fig. 7 of Embodiment 1 and to use the upper flat mold 96 and the lower mold 95 that push the infrared-absorbing film toward the substrate 1 in Embodiment 6 is eliminated.

### [Embodiment 8]

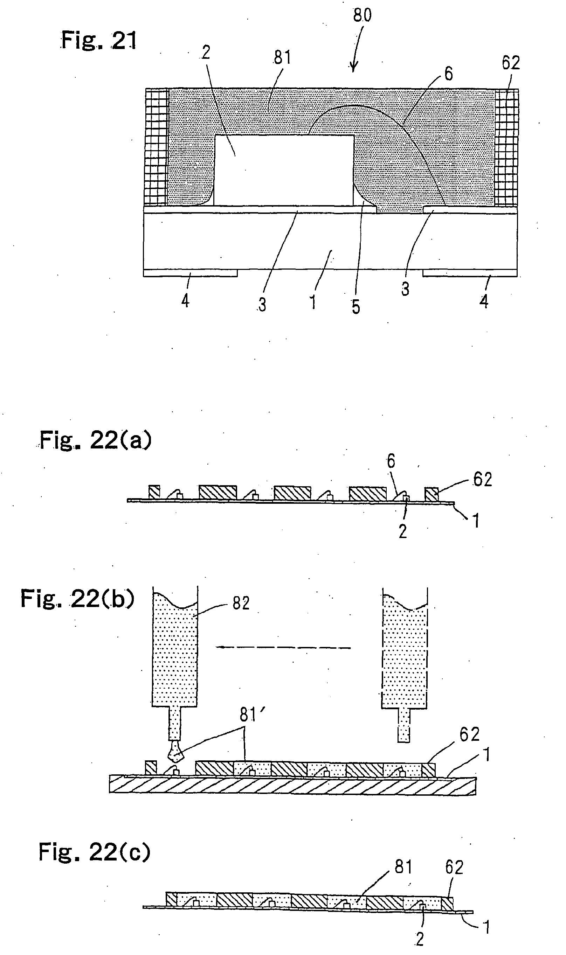

Fig. 21 is a front view in section of an optical sensor according to Embodiment 8 of the present invention; and Fig. 22 is a flowchart showing the step of forming the resin encapsulating portions in the production of the optical sensor according to Embodiment 8.

In Embodiment 8, a transparent resin encapsulating portion 81 contains infrared-absorbing substances (as in the case with Embodiment 4 shown in Fig. 13) and the light-shielding frames 62 are provided around the transparent resin encapsulating portions 81., respectively. Like reference numerals denote like parts in Embodiment 1 and explanations thereon are omitted.

A process of producing an optical sensor 80 of Embodiment 8 is as follows. In the step of forming the resin encapsulating portions, a light-transmissive-resin-encapsulating-portion formation resin 81' containing the infrared-absorbing dyes is injected by using a dispenser 82 into each light-shielding frame 62 on the substrate 1 to the brirn, as shown in Fig. 22(a) and Fig. 22(b). When resin 81' is cured, the step is finished. Then, the substrate is sectioned to complete the individual optical sensors 70 as products.

In the optical sensor 70 according to Embodiment 80, the light-shielding frame 62 covers all the side surfaces of the photodetector 2 except the light-receiving surface 2a so that all light that enters the photodetector 2 passes through the infrared-absorbing layer 12 to ensure that the optical sensor has an improved characteristic of blocking infrared radiation in addition to the same effect as obtained in Embodiment 1. In the process of producing the optical sensor 80, the light-shielding frame 62 serves as a frame for use in the formation the transparent resin encapsulating portion 11. Therefore, the need to use the upper mold illustrated in Fig. 7 of Embodiment 1 is eliminated, and the transparent resin encapsulating portion 81 and the infrared-absorbing layer can be formed in the same step.

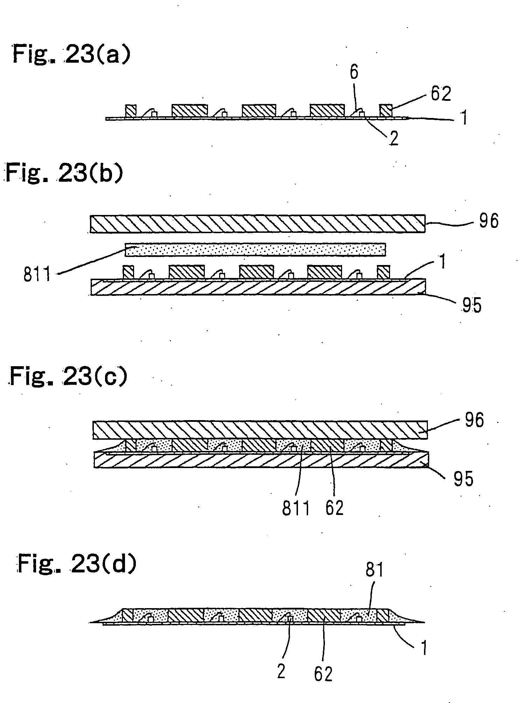

Meanwhile, in Embodiment 8, the resin encapsulating portions may be formed as shown in Fig. 23. First, the substrate 1 having the light-shielding portions 62 as shown in Fig. 23(a) is set in the lower mold 95 as shown in Fig. 23(b). Next, a sheet resin 811., containing two or more infrared-absorbing dyes, of B stage type, a type of transparent resin having been cured midway, is placed on the light-shielding frames 62. After that, hot pressing with the upper mold 96 and the lower mold 95 is carried out as shown in Fig. 23(c) to obtain a molded resin part as shown in Fig. 23 (d). Then, the substrate is sectioned to complete the individual sensors 70 as products.

### [Other embodiments]

1. Transfer molding in the production processes of Embodiments 1 and 4 may be replaced by low-pressure molding. More specifically, the step of forming the resin encapsulating portion may comprise: interposing the substrate, having the plurality of photodetectors mounted thereon, between the upper mold and the lower mold, the upper mold having in correspondence with the photodetectors the plurality of recesses to be used for formation of the light-transmissive resin encapsulating portions; pouring a light-transmissive resin having a low viscosity by using a dispenser through one injection port formed in one of the molds so that the resin flows through a branched resin passageway into each recess inside the mold; and then allowing the resin to cure thereby to form the resin encapsulating portions (see Figs. 7(a) to 7(d)). This type of formation step, owing to a wide choice of resins and low costs of the molds., is effective in producing small batches of a variety of products.
2. The infrared-absorbing layer (infrared-absorbing film) used as the infrared-blocking layer in Embodiments 1, 2 3 and 6 may be replaced by an infrared-reflecting layer (infrared radiation reflecting film).
3. The double-layer structure of the light-transmissive resin encapsulating portion with the outer resin portion covering the inner resin portion entirely in Embodiments 2 and 5 may be such that a lateral surface of the inner resin portion is exposed to the outside.

According to the present invention, the function of absorbing or reflecting light in the infrared region can be incorporated in the optical sensor without an increase in the number of components, so that it is possible to save time and effort to incorporate, separately from the optical sensor, an infrared-blocking filter into electronic apparatus such as a personal digital assistant, making it possible to manufacture electronic apparatus at a low cost without an increase in the number of assembly steps. Also, by using the photodetector having a peak sensitivity in the visible-light region, control can be made on a criterion closer to the one applied by the human eye.

## Claims

1. An optical sensor comprising.: a substrate having an electrode; a photodetector electrically connected to the electrode; and a ligh-t-transmissive resin encapsulating portion for encapsulating the photodetector on the substrate, the optical sensor **characterized by** further comprising an infrared-blocking layer either inside the light-transmissive resin encapsulating portion or on an outer surface of the light-transmissive resin encapsulating portion for blocking infrared radiation from the outside from reaching the photodetector.

2. An optical sensor comprising: a substrate having an electrode; a photodetector electrically connected to the electrode; and a light-transmissive resin encapsulating portion for encapsulating the photodetector on the substrate, the optical sensor **characterized in that** the light-transmissive resin encapsulating portion contains an infrared-absorbing substance.

3. The optical sensor as set forth in claim 1, wherein the infrared-blocking layer is formed on the outer surface of the light-transmissive resin encapsulating portion and is either an infrared-absorbing layer containing an infrared-absorbing substance or an infrared-reflecting layer containing an infrared-reflecting substance.

4. The optical sensor as set forth in claim 1, wherein the light-transmissive resin encapsulating portion has an inner resin portion for encapsulating the photodetector and an outer resin portion for covering the inner resin portion and wherein the infrared-blocking layer is interposed between the inner resin portion and the outer resin portion and is either an infrared-absorbing layer containing an infrared-absorbing substance or an infrared-reflecting layer containing an infrared-reflecting substance.

5. The optical sensor as set forth in any one of claims 2 to 4, wherein the infrared-absorbing substance is a phthalocyanine compound represented by the general formula (I): 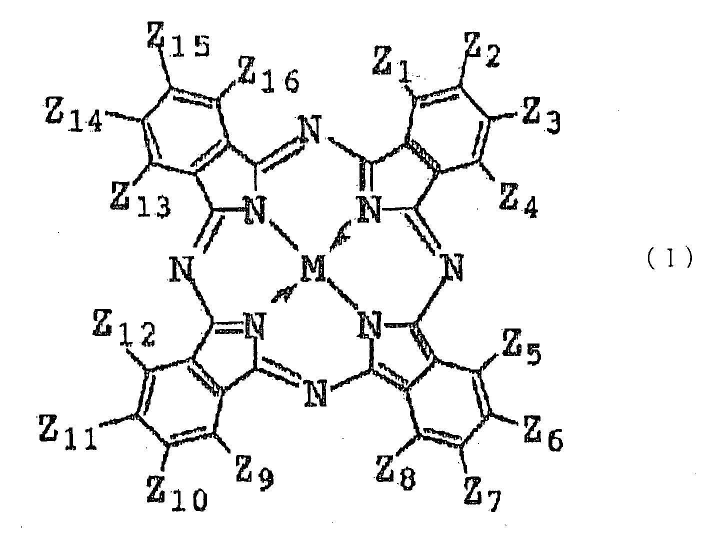 wherein Zi (i=1-16) is SR₁, OR₂, NHR₃ or a halogen atom, wherein R₁, R₂ and R₃ are a phenyl group which may have substituent(s), an aralkyl group which may have substituent(s) or a C₁-C₂₀ alkyl group which may have substituent(s); and M is a nonmetal, a metal, a metallic oxide or a metallic halide.

6. The optical sensor as set forth in any one of claims 1 to 5, further comprising a light-shielding frame for covering all the outer surfaces of the light-transmissive resin encapsulating portion except an outer surface thereof on a light-receiving surface side of the photodetector.

7. The optical sensor as set forth in any one of claims 1 to 6, wherein the transmittance of the light-transmissive resin encapsulating portion in the visible-light region is substantially conslant in the range of blue light (450 nm) to red light (650 nm).

8. The optical sensor as set forth in any one of claims 2 to 7, containing two or more different infrared-absorbing substances.

9. The optical sensor as set forth in claim 8, wherein the two or more different infrared-absorbing substances are phthalocyanine compounds having absorption peaks at different infrared wavelengths.

10. The optical sensor as set forth in claim 9, wherein the infrared-absorbing substances are phthalocyanine compounds having absorption peaks in the range of wavelengths of 750 nm to 1000 nm.

11. The optical sensor as set forth in any one of claims 1 to 10, wherein the photodetector is a Si phototransistor.

12. A process of producing an optical sensor, comprising the steps of: electrically connecting a photodetector to an electrode provided on a substrate; and forming a light-transmissive resin encapsulating portion on the substrate so that the photodetector is entirely encapsulated in the light-transmissive resin encapsulating portion, the process **characterized in that** the step of forming the light-transmissive resin encapsulating portion includes the step of forming an infrared-blocking layer either inside the light-transmissive resin encapsulating portion or on an outer surface of the light-transmissive resin encapsulating portion for blocking infrared radiation from the outside from reaching the photodetector.

13. A process of producing an optical sensor, comprising the steps of: electrically connecting a photodetector to an electrode provided on a substrate; and forming a light-transmissive resin encapsulating portion on the substrate so that the photodetector is entirely encapsulated in the light-transmissive resin encapsulating portion, the process **characterized in that** in the step of forming the light-transmissive resin encapsulating portion, the light-transmissive resin encapsulating portion is formed of a transparent resin containing an infrared-absorbing substance.

14. The process of producing an optical sensor as set forth in claim 12, wherein the step of forming the infrared-blocking layer includes forming, on the outer surface of the light-transmissive resin encapsulating portion, either an infrared-absorbing layer containing an infrared-absorbing substance or an infrared-reflecting layer containing an infrared-reflecting substance.

15. The process of producing an optical sensor as set forth in claim 12, wherein the step of forming the resin encapsulating portion includes the steps of: forming an inner resin portion for encapsulating the photodetector; forming the infrared-blocking layer for covering an outer surface of the inner resin portion with either an infrared-absorbing layer containing an infrared-absorbing substance or an infrared-reflecting layer containing an infrared-reflecting substance; and forming an outer resin portion for covering an outer surface of either the infrared-absorbing layer or the infrared-reflecting layer.

16. The process of producing an optical sensor as set forth in any one of claims 12 to 15, further comprising the step of forming a light-shielding frame for covering all the outer surface of the light-transmissive resin encapsulating portion except an outer surface thereof on a light-receiving surface side of the photodetector, the step of forming the light-shielding frame being carried out before the step of forming the resin encapsulating portion.

17. The process of producing an optical sensor as set forth in any one of claims 12 to 16., wherein the step of forming the resin encapsulating portion comprises: holding the substrate, having a plurality of said photodetectors mounted thereon, between an upper mold and a lower mold, the upper mold having, in correspondence with the photodetectors, a plurality of recesses to be used for formation of the light-transmissive resin encapsulating portion; pouring a light-transmissive resin into the recesses inside the mold; and then curing the resin thereby to form the resin encapsulating portions.

18. A light-transmissive resin composition both for an optical sensor filter and for encapsulating a photodetector of an optical sensor, the light-transmissive resin composition having an infrared radiation blockage function provided by addition of a plurality of phthalocyanine dyes as infrared-absorbing substances to a light-transmissive resin.
